(19) Europäisches Patentamt
European Patent Office
Office européen des brevets

(11) Publication number : **0 488 748 A1**

(12) # EUROPEAN PATENT APPLICATION

(21) Application number : **91311046.6**

(51) Int. Cl.$^5$ : **G03F 7/039,** C08F 12/22

(22) Date of filing : **28.11.91**

(30) Priority : **28.11.90 JP 328249/90**

(43) Date of publication of application :
**03.06.92 Bulletin 92/23**

(84) Designated Contracting States :
**DE FR GB**

(71) Applicant : **Shin-Etsu Chemical Co., Ltd.**
**6-1, Otemachi 2-chome**
**Chiyoda-ku Tokyo 100 (JP)**

(72) Inventor : **Yamada, Motoyuki Room no. 404**
**Rinwa Sunny Court**
**No. 259, Shimosakunobe Takatsu-ku**
**Kawasaki-shi**
**Kanagawa-ken (JP)**
Inventor : **Watanabe, Osamu Room No. 309**
**Aobadai Apt.**
**28-1, Aobadai 1-chome Midori-ku**
**Yokohama-shi**
**Kanagawa-ken (JP)**
Inventor : **Yagihashi, Fujio Room No. 101**
**Aobadai Apt.**
**28-1, Aobadai 1-chome Midori-ku**
**Yokohama-shi**
**Kanagawa-ken (JP)**
Inventor : **Takamizawa, Minoru 8-21, Kitazawa**
**4-chome**
**Setagaya-ku**
**Tokyo (JP)**

(74) Representative : **Stoner, Gerard Patrick et al**
**Mewburn Ellis 2 Cursitor Street**
**London EC4A 1BQ (GB)**

(54) **Resist compositions.**

(57) A resist based on a living polymer is provided. Living anionic polymerization of p-alkoxystyrene monomers results in polymers having a molecular weight distribution (Mw/Mn) of 1 to 1.4.

EP 0 488 748 A1

This invention relates to a resist composition for use in forming a fine pattern on the surface of semiconductor elements using ultraviolet or far ultraviolet light, and to manufacture and use of such compositions.

With the advance of LSI technology, the memory capacity of IC chips reaches an order of mega bits and a rule of submicron is thus required for the fineness of wiring pattern. Accordingly, lithography light sources are shifting toward shorter wavelength from the ultraviolet band to the far ultraviolet band which is more advantageous for fine patterning. Also, the current mainstream of etching step involved in the LSI manufacturing process is dry etching using RF plasma.

In these circumstances, the lithography technology uses resists which have to be sensitive and transmissive to the wavelength used and resistant against dry etching. More particularly, novolak type resins and other aromatic resins are useful resists for use in photolithography, especially G and I ray lithography in view of light transmittance at the wavelength used and plasma etching resistance.

However, the light source intensity of far ultraviolet light, including mercury line spectrum on a shorter wavelength side than G and I rays and excimer laser light such as KrF and ArF, is extremely weaker than the light source intensity of G and I rays. Utilization of such ultraviolet light in photolithography has the problem that prior art resists conventionally used with G and I rays provide unacceptable exposure sensitivity and low light transmittance to far ultraviolet light. There is a need for a new type of resist.

Resists of the chemically amplified type were developed as a substitute for the conventional resists. For example, Japanese Patent Application Kokai (JP-A) No. 45439/1984 discloses a resist composition comprising p-tert-butoxycarbonyloxy-α-methylstyrene which is one of acid unstable polymers having recurring branched groups and a diaryl iodonium salt which is one of photo-polymerization initiators capable of generating acid upon exposure to radiation. Upon exposure of the resist to far ultraviolet light, the diaryl iodonium salt decomposes to generate an acid which in turn, cases cleavage of the p-tert-butoxycarbonyl group of p-tert-butoxycarbonyloxy-α-methylstyrene into a polar group. Then a desired pattern is obtained by dissolving away the thus exposed areas or unexposed areas with base or non-polar solvent.

JP-A 115440/1987 discloses a resist composition comprising poly-4-tert-butoxy-α-styrene and di(tert-butylphenyl) iodonium trifluoromethane sulforonate which are dissolved in diglyme and then exposed to far ultraviolet light. This resist achieves a high degree of resolution through the same reaction mechanism as the resist of JP-A 45439/1984.

The polymers used in these well-known resists as a major component are obtained by conventional radical or cationic polymerization of corresponding monomers. It was never attempted to control the molecular weight distribution of the polymers. That is, no special attention was paid to the molecular weight distribution of polymers. According to the inventors' investigations, if a resist based on a polymer having a wide molecular weight distribution is used, a low molecular weight moiety of the polymer can be gasified during the vacuum step involved in the wafer manufacturing process, resulting in a lowering of vacuum and contamination of the processing atmosphere. There always arises the problem that the polymer locally experiences a fast or slow dissolution rate due to uneven molecular weight distribution. As a result, an unstable state of patterning will often occur.

Problems addressed herein include the provision of novel resist compositions, methods for making them and use thereof. In preferred aspects, it is sought to eliminate or at least reduce the above-mentioned problems, and to provide techniques useful for super LSI applications.

The inventors have found that living anionic polymerization of a monomer having rational formula (1):

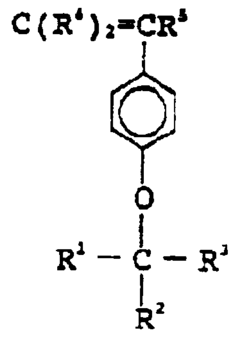

(1)

wherein $R^1$ to $R^4$ are independently hydrogen or an alkyl group having 1 to 12 carbon atoms, and $R^5$ is hydrogen or a methyl group results in a living polymer having a narrow molecular weight distribution of from 1 to 1.4. The molecular weight distribution used herein is defined as the weight average molecular weight divided by the number average molecular weight, i.e., Mw/Mn.

It is possible to control the molecular weight of the living polymer to a desired value. A resist based on such a polymer having a narrow molecular weight distribution can provide sufficient exposure sensitivity relative to ultraviolet and far ultraviolet light without a loss of light intensity and solve the problem of the prior art including a lowering of vacuum during a vacuum step in wafer manufacturing process, contamination of the processing atmosphere, a varying polymer dissolving rate, and unstable patterning. Resists embodying the invention are thus adapted for the manufacture of super LSI.

## BRIEF DESCRIPTION OF THE DRAWINGS

FIGS. 1 and 2 are GPC elution curves of the polymers prepared in Preparations 1 and 2.

FIG. 3 is a GPC elution curve of the polymer prepared in Comparative Example.

## DETAILED DESCRIPTION

The polymer which constitutes a predominant component of the resist according to the present invention is obtainable by living anionic polymerization of a monomer having rational formula (1).

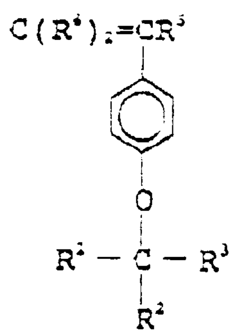

(1)

In formula (1), $R^1$ to $R^4$ are independently selected from the group consisting of a hydrogen atom and an alkyl group having 1 to 12 carbon atoms, preferably 1 to 3 carbon atoms, and $R^5$ is a hydrogen atom or a methyl group. The monomers may be used alone or in admixture of two or more. That is, the polymers may be homopolymers or copolymers. Most preferred monomer is p-tert-butoxystyrene because of low cost and ease of living polymerization.

For living polymerization of the monomers, polymerization initiators are often used. Organometallic compounds are preferred initiators. Exemplary are organic alkali metals including n-butyllithium, sec-butyllithium, tert-butyllithium, sodium naphthalene, sodium anthracene, disodium α-methylstyrene tetramer, cumylpotassium, and cumylcecium.

Living polymerization of the monomers is generally carried out in organic solvents. Examples of the organic solvent used include cyclic ethers, benzene, toluene, tetrahydrofuran, dioxane, tetrahydropyran, dimethoxyethane, n-hexane, and cyclohexane, alone or in admixture of two or more.

In living polymerization of monomers of rational formula (1), optimum reaction conditions including a living polymerization initiator and the concentration of monomer in organic solvent vary with a choice of a particular functional group in the monomer. To predetermine optimum conditions, a preliminary experiment is preferably carried out. In general, monomers to be polymerized are present in organic solvents in concentrations of 1 to 50% by weight, preferably 5 to 30% by weight. The amount of the polymerization initiator is determined from the ratio of the weight of the monomer to the molecular weight of the polymer.

The monomers can be polymerized by stirring their organic solvent solution after the reaction system is evacuated to vacuum with or without subsequent purging the atmosphere with inert gas such as argon and nitrogen. The reaction temperature may range from -100°C to the boiling point of the solvent. For example, a reaction temperature of -100°C is selected for tetrahydrofuran system and room temperature is selected for benzene system.

Living polymerization continuously proceeds since a carbanion does not attack ether oxygen at the para-position of a phenyl group and a vinyl group in the styrene moiety is selectively polymerized. Polymerization reaction is generally complete within about 10 minutes to about 5 hours. There are obtained polymers represented by formula (2).

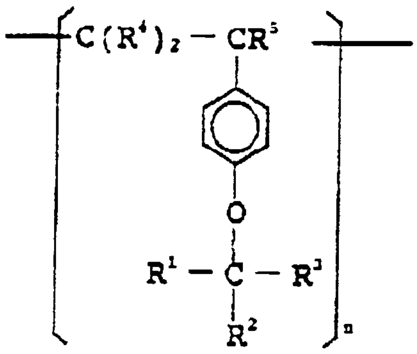

(2)

wherein n is 10 or more, preferably 10 to 1000, more preferably 50 to 1000.

Thereafter, a stopper such as methanol, water, and methylbromide is added to the reaction solution to terminate the reaction. If necessary, the polymer is purified and isolated from the reaction solution by adding methanol to the solution for causing the reactants to precipitate, followed by washing and drying. Often, such purification is desirable because the polymer at the end of reaction generally contains unreacted reactants and by-products as impurities. If such a polymer is used as a resist in the manufacture of super LSI without purification, the impurities can be detrimental to the wafer manufacturing process.

With respect to molecular weight distribution, the thus obtained polymers are mono-disperdes. Particularly, polymers having a desired narrow molecular weight distribution Mw/Mn of from 1 to 1.4 are obtained. A Mw/Mn of more than 1.4 will offset the living polymerization effect so that an unstable state can occur during patterning due to low molecular weight polymer components.

There are obtained polymers in a yield of approximately 100% based on the monomers used. The molecular weight of a polymer can be readily calculated from the weight of a monomer used and the moles or molecular weight of a polymerization initiator. The number average molecular weight (Mn) is determined through measurement by a membrane osmometer and the molecular weight distribution is determined by gel permeation chromatography (GPC), with which a polymer can be characterized to evaluate whether it is a desired one or not.

The resist composition of the invention contains the polymer as a predominant component, and it may further contain additional components such as an onium salt cationic photo-initiator and inert organic solvent. The onium salt cationic photo-initiator is to generate strong acid upon exposure to light. In a wafer stepper, the onium salt in the resist film is decomposed to generate strong acid which in turn, causes cleavage of a group of formula (3) in the living polymer into a group of formula (4).

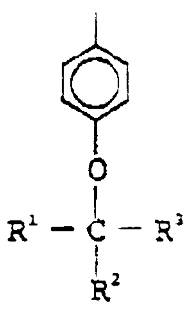

(3)

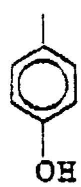

(4)

As a result, the polymer is converted into an alkali soluble polymer.

Examples of the onium salt cationic photo-initiator are given below.

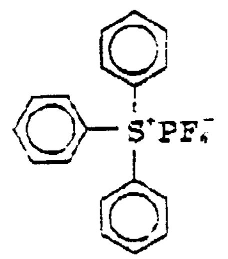

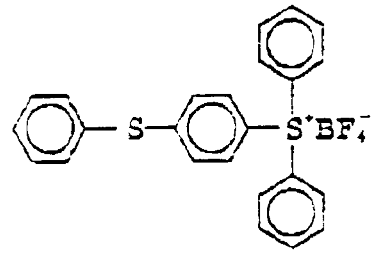

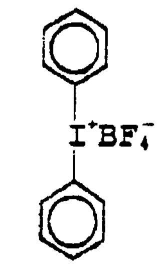

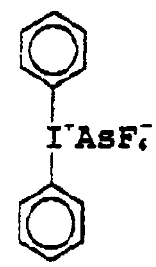

Other useful onium salt cationic photo-initiators are disclosed in JP-A 45439/1984 or USP 4,491,628, 115440/1987 or USP 4,603,101, JP-A 300250/1989, and USP 4,537,854. The initiators are not limited to these examples and any substances capable of generating acid upon exposure to light may be used.

Preferably the onium salt cationic photo-initiators are blended in amounts of about 0.01 to about 20% by weight, more preferably about 1 to about 10% by weight of the resist composition.

In practice, the resist is used in solution form by dissolving the resist in a several times large volume of organic solvent. A choice is made of the organic solvent in which the resist based on the living polymer according to the invention is well soluble and which allows a resist film to uniformly spread. Exemplary are butyl acetate, acetone, and cellosolve acetate and 1-methoxy-2-propanol, with butyl acetate being most preferred. The organic solvents may be used alone or in admixture of two or more.

The concentration of the polymer in the solution may be in the range of about 10 to about 20% by weight, although it is determined from the relation among the thickness, solvent to be used, and viscosity.

The use and light exposure of the resist may be in accord with the well-known conventional lithography. In particular, the resist of the invention is adapted for fine patterning with ultraviolet and far ultraviolet light having a wavelength of 254 to 193 nm.

We have found that such resist compositions, containing as a predominant component a polymer having a desired molecular weight and a narrow molecular weight distribution, can provide sufficient exposure sensitivity relative to ultraviolet and far ultraviolet light without a lowering of light intensity, and eliminate problems including a lowering of vacuum during a vacuum step in wafer manufacturing process, contamination of the processing atmosphere, a varying polymer dissolving rate, and unstable patterning. It is thus possible to obtain resist suited for the manufacture of super LSI.

## EXAMPLE

Examples of the present invention are given below by way of illustration and not by way of limitation. Before entering the examples, it is first described how to prepare a polymer.

### Preparation 1

The reactant used was p-tert-butoxystyrene monomer commercially available from Hokko Chemical K.K. which was pretreated with $CaH_2$ to remove water and impurities, refined with sodium benzophenone, and distilled. A 1-liter flask was charged with 600 ml of tetrahydrofuran solvent and 3.5 X $10^{-3}$ mol of n -butyllithium as a polymerization initiator. To the mixture was added 35 grams of the refined p-tert-butoxystyrene monomer diluted with 100 ml of tetrahydrofuran at -78°C. Polymerization reaction took place for one hour whereupon the solution turned red. Polymerization was terminated by adding methanol to the reaction solution. The reaction solution was poured into methanol whereby the polymer was precipitated and thereafter, separated therefrom and purified. Drying yielded 35 grams of a white polymer.

FIG. 1 is the GPC elution curve of the polymer. By membrane osmometry, the number average molecular

weight (Mn) of the polymer was measured to be 1.1 X $10^4$/mol. The molecular weight distribution (Mw/Mn) was 1.17.

Preparation 2

The reactant used was p-tert-butoxy-α-methylstyrene monomer which was dried and purified in the same manner as in Preparation 1. A 2-liter flask was charged with 1500 ml of tetrahydrofuran solvent and 4.5 X $10^{-3}$ mol of sec-butyllithium as a polymerization initiator. To the mixture was added 90 grams of the refined p-tert-butoxy-α-methylstyrene monomer diluted with 200 ml of tetrahydrofuran at -95°C. Polymerization reaction took place for two hours whereupon the solution turned red. Polymerization was terminated by adding methanol to the reaction solution. The reaction solution was poured into methanol whereby the polymer was precipitated and thereafter, separated therefrom and purified. Drying yielded 89 grams of a white polymer.

FIG. 2 is the GPC elution curve of the polymer. By membrane osmometry, the number average molecular weight (Mn) of the polymer was measured to be 1.9 X $10^4$/mol. The molecular weight distribution (Mw/Mn) was 1.07.

Example

Polymer solutions were obtained by dissolving 2 grams of the polymers obtained in Preparations 1 and 2, respectively, in 12 ml of butyl acetate along with 0.15 grams of an onium salt represented by the following formula.

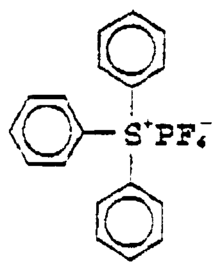

The polymer solutions were coated to one surface of silicon wafers by means of a spin coater and dried into polymer films of 1.0 μm thick (Preparation 1) and 1.2 μm thick (Preparation 2). Using a stepper having built therein a light source for emitting light at a wavelength of 254 nm, the wafers were exposed to light, developed, and post-treated in a conventional manner. Both the polymer films had a line-and-space resolution of 0.4 μm.

Comparative Example

In a notrogen purged vessel, a solution of 0.1 gram of 2,2-azobisisobutyronitrile in 5 grams of p-tert-butoxystyrene monomer was subjected to polymerization reaction for 10 hours at 70°C. The resulting polymer was purified as in Preparation 1. The GPC elution curve of the polymer is shown in FIG. 3. The polymer had a number average molecular weight (Mn) of 2.0 X $10^4$/mol and a molecular weight distribution (Mw/Mn) of 2.25.

A polymer solution was obtained by dissolving 2.0 grams of the polymer in 12 ml of cyclohexane along with 0.15 grams of the same onium salt as in Example. As in Example, the polymer solution was coated and then exposed to light by means of the stepper. The patterns obtained on this polymer film were satisfactory at a distance of up to 0.6 μm to an adjoining pattern, but fine patterns of less than 0.6 μm showed trapezoidal rounded corners, with unresolved areas being partially observed.

## Claims

1. A resist composition predominantly comprising a polymer obtainable by living anionic polymerization of a monomer having the rational formula (1):

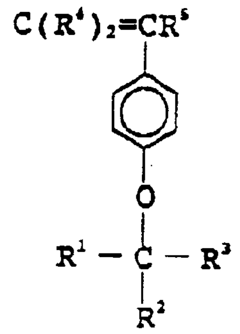

(1)

wherein $R^1$ to $R^4$ are independently selected from the group consisting of hydrogen and alkyl groups having 1 to 12 carbon atoms, and $R^5$ is hydrogen or a methyl group, the polymer having a molecular weight distribution of 1 to 1.4.

2. The composition of claim 1 which further comprises an onium salt cationic photo-initiator capable of generating strong acid upon exposure to light and an organic solvent.

3. A method comprising the manufacture of a composition according to claim 1 or claim 2, comprising forming the polymer by living anionic polymerization.

4. Use of a composition according to claim 1 or claim 2 as a resist composition.

5. Use according to claim 4, with ultraviolet light of wavelength 254 to 193nm.

FIG. 1

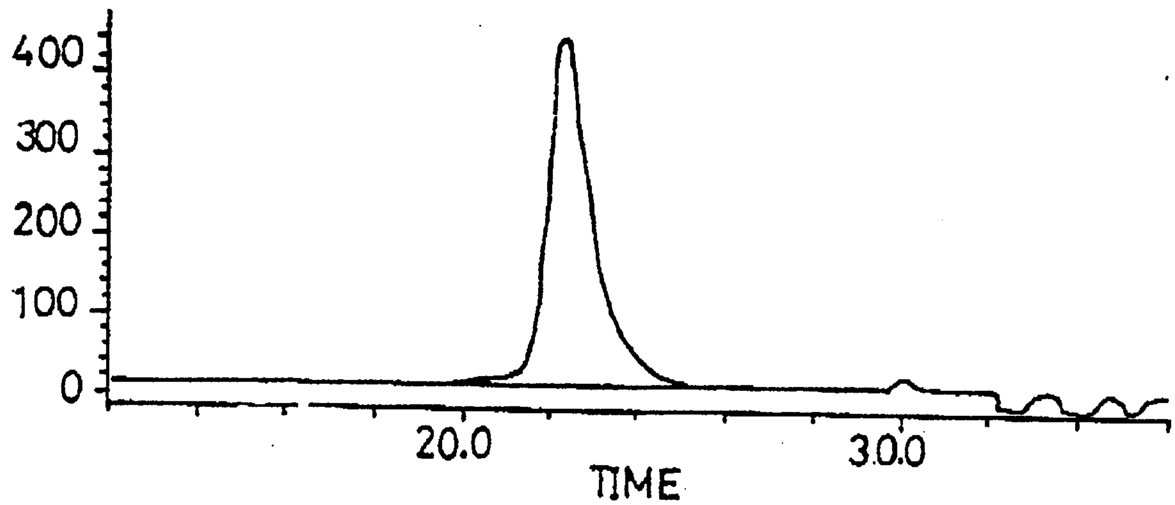


FIG. 2

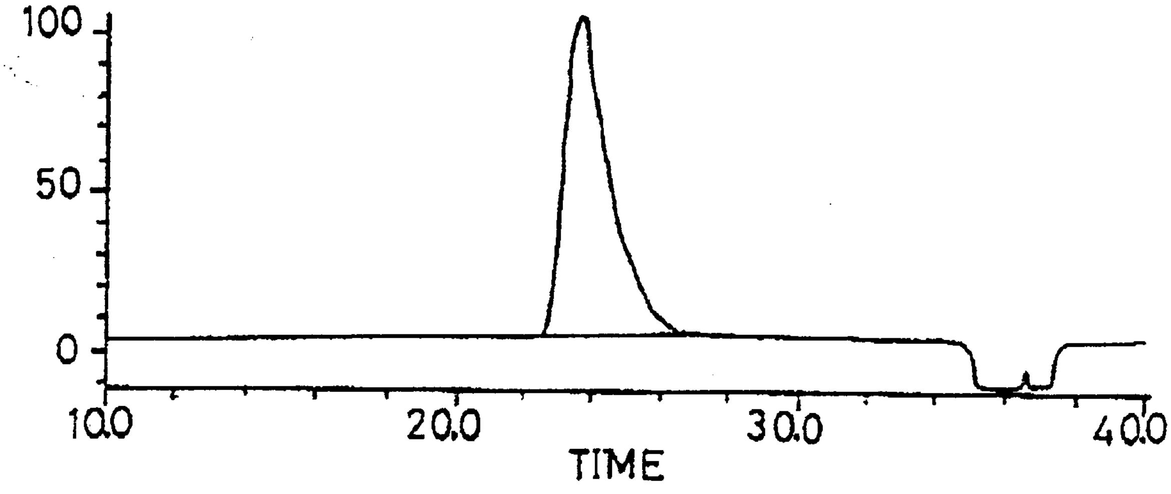

FIG. 3

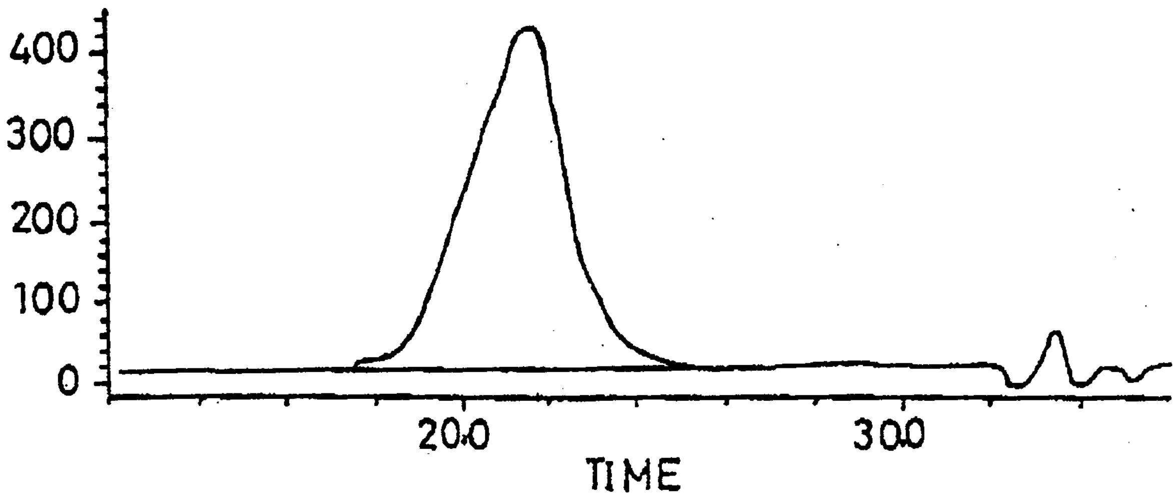

European Patent Office

# EUROPEAN SEARCH REPORT

Application Number

EP 91 31 1046

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | US-A-4 603 101 (CRIVELLO J.V.)<br>* the whole document *<br>--- | 1-5 | G03F7/039<br>C08F12/22 |
| Y | EP-A-0 102 450 (INTERNATIONAL BUSINESS MACHINES CORPORATION)<br>* the whole document *<br>--- | 1-5 | |
| Y | CHEMICAL ABSTRACTS, vol. 105, no. 2, 14 July 1986, Columbus, Ohio, US;<br>abstract no. 6890,<br>NAKAHAMA SEIICHI: 'Anionic living polymerisation of protected fonctional monomers'<br>page 5 ;<br>* the whole document *<br>* abstract *<br>----- | 1-5 | |

TECHNICAL FIELDS SEARCHED (Int. Cl.5 )

G03F

The present search report has been drawn up for all claims

| Place of search | Date of completion of the search | Examiner |
|---|---|---|
| THE HAGUE | 17 MARCH 1992 | LUDI M.M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)